# EUROPÄISCHE PATENTSCHRIFT

(11) **EP 3 262 728 B1**
(45) Veröffentlichungstag und Bekanntmachung des Hinweises auf die Patenterteilung: **25.01.2023**
(21) Anmeldenummer: 16706579.6
(22) Anmeldetag: 24.02.2016
(51) Int. Cl.: H01S 5/022, H01S 5/40

(54) **VERFAHREN ZUM HERSTELLEN EINES DIODENLASERS UND DIODENLASER**
METHOD FOR PRODUCING A DIODE LASER AND DIODE LASER
PROCÉDÉ DE FABRICATION D'UN LASER À DIODE ET LASER À DIODE

(30) Priorität: 24.02.2015 DE 102015002176
(43) Veröffentlichungstag der Anmeldung: 03.01.2018
(73) Patentinhaber: JENOPTIK Laser GmbH, 07745 Jena (DE)
(72) Erfinder: HÜLSEWEDE, Ralf, 15711 Königs-Wusterhausen (DE); SCHRÖDER, Matthias, 99425 Weimar (DE); LOYO-MALDONADO, Valentin, 07749 Jena (DE)
(74) Vertreter: Waldauf, Alexander
(86) Internationale Anmeldenummer: PCT/EP2016/053802
(87) Internationale Veröffentlichungsnummer: WO 2016/135160

(56) Entgegenhaltungen:
- EP-A1- 2 053 709
- WO-A1-2011/029846
- JP-A- 2014 027 179
- US-A1- 2006 029 117
- US-A1- 2007 181 891

## Beschreibung

### Technisches Gebiet

Die Erfindung betrifft ein Verfahren zum Herstellen eines Diodenlasers, einen Diodenlaser und die Verwendung einer metallischen Schicht zur Herstellung einer Klemmverbindung in einem Diodenlaser. Der

Diodenlaser umfasst einen Laserbarren, der zwischen einem Wärmeleitkörper und einem Deckel angeordnet ist. Der Wärmeleitkörper und der Deckel dienen als elektrische Kontakte, durch die der Betriebsstrom zum Laserbarren geleitet wird.

### Stand der Technik

Seit langer Zeit bekannt sind Verfahren zum Herstellen eines Diodenlasers, bei welchen ein Laserbarren p-seitig auf eine Wärmesenke gelötet wird und n-seitig eine Kontaktierung über Bonddrähte erfolgt, z. B. aus US 5105429 A und US 4716568 A. Nachteilig ist die begrenzte Stromtragfähigkeit der Bonddrähte.

Eine höhere Stromtragfähigkeit des n-seitigen Stromanschlusses kann durch die Verwendung eines massiven Deckels, der als zweiter Wärmeleitkörper ausgebildet sein kann, erreicht werden. Aus WO 2009143835 und aus WO 2009146683 ist bekannt, den Laserbarren zwischen zwei Wärmeleitkörpern anzulöten. Der Lötprozess kann zu Verspannungen im Laserbarren führen, welche die elektrooptischen Eigenschaften beeinträchtigen können. Aus WO 2011029846 ist ein Verfahren zum Herstellen eines Diodenlasers ohne Beteiligung eines Lötprozesses bekannt, bei dem eine erste metallische Schicht zwischen der ersten Kontaktfläche des Laserbarrens und dem ersten Wärmeleitkörper und eine zweite metallische Schicht zwischen der zweiten Kontaktfläche des Laserbarrens und dem zweiten Wärmeleitkörper verwendet werden. Diese Schichten, die beispielsweise aus Indium bestehen können, bewirken bei der Klemmung einen Stoffschluss. Nachteilig ist, dass sehr hohe Anforderungen an die Ebenheit des Laserbarrens und an die Ebenheit der Anschlussflächen der beiden Wärmeleitkörper und an die Einhaltung der Parallelität der Flächen bei der Montage gestellt werden müssen. Abweichungen im µm-Bereich können bereits zu großflächigen Hohlstellen führen, an denen kein Stoffschluss vorhanden ist. Insbesondere kann ein mangelhaft ausgebildeter Stoffschluss an der p-seitigen Kontaktfläche des Laserbarrens zu einer Überhitzung und sogar zum Abbrand des Laserbarrens führen. Außerdem kann eine Migration von Material der Indiumschichten auftreten. Dadurch kann es zum Ausfall des Lasers kommen.

### Aufgabe der Erfindung

Aufgabe der Erfindung ist es, ein Verfahren zum Herstellen eines Diodenlasers anzugeben, das für einen hohen Betriebsstrom ausgelegt ist. Der Laserbarren soll bei der Montage und im Betrieb möglichst keine unerwünschten mechanischen Verspannungen erfahren, welche die elektrooptischen Eigenschaften beeinträchtigen könnten. Das Verfahren soll tolerant gegen Unebenheiten des Laserbarrens und/oder der Kontaktflächen des Wärmeleitkörpers bzw. des Deckels sein. Die p-seitige Kontaktfläche des Laserbarrens (Epitaxieseite), die dem Wärmeleitkörper zugewandt ist, soll nach der Montage eine bestmögliche Ebenheit aufweisen. Für den Laserbarren soll dadurch ein möglichst geringer smile-Wert erreicht werden. Die Ausfallwahrscheinlichkeit des Diodenlasers soll gering sein. Neben dem Verfahren zur Herstellung soll ein derart vorteilhafter Diodenlaser angegeben werden.

### Lösung der Aufgabe

Die Aufgabe wird gelöst durch ein Verfahren zum Herstellen eines Diodenlasers, umfassend folgende Schritte:
a. Bereitstellen wenigstens eines Laserbarrens, der auf einer ersten Seite eine erste Kontaktfläche aufweist, die als wenigstens ein p-Kontakt ausgebildet ist, und auf einer der ersten Seite gegenüberliegenden zweiten Seite, der Substratseite des Laserbarrens, eine zweite Kontaktfläche aufweist, die als wenigstens ein n-Kontakt ausgebildet ist,
b. Bereitstellen eines Wärmeleitkörpers mit einer ersten Anschlussfläche,
c. Bereitstellen eines Deckels mit einer zweiten Anschlussfläche,
d. Bereitstellen einer ersten metallischen Schicht, wobei die erste metallische Schicht eine gleichmäßige Schichtdicke aufweist,
e. Bereitstellen einer zweiten metallischen Schicht als Noppenstruktur, welche in einer Schnittebene mehrere erhabene Stellen und mehrere abgesenkte Stellen aufweist, wobei die zweite metallische Schicht, bezogen auf die erhabenen Stellen, dicker ausgeführt ist als die erste metallische Schicht, wobei die zweite metallische Schicht Indium umfasst, und wobei die Noppenstruktur eine Belegungsdichte mit wenigstens einer Noppe je Quadratmillimeter Schichtfläche aufweist,
f. Anordnen des Laserbarrens zwischen dem Wärmeleitkörper und dem Deckel, wobei
   die erste Kontaktfläche der ersten Anschlussfläche des ersten Wärmeleitkörpers zugewandt ist und die zweite Kontaktfläche der zweiten Anschlussfläche des Deckels zugewandt ist und beim Anordnen des Laserbarrens die erste metallische Schicht zumindest abschnittsweise zwischen der ersten Anschlußfläche und der ersten Kontaktfläche angeordnet ist und die zweite metallische Schicht zumindest abschnittsweise zwischen
   der zweiten Anschlussfläche und der zweiten Kontaktfläche angeordnet ist,
g. Erzeugen wenigstens einer Kraft, die eine Komponente aufweist, welche den Deckel
   in Richtung des Wärmeleitkörpers drückt, wobei unter der Einwirkung der Kraft die erste Kontaktfläche flächig auf die erste Anschlussfläche gedrückt wird, wobei die zweite metallische Schicht zumindest abschnittsweise im Bereich der erhabenen Stellen eine plastische Verformung erfährt, und
h. Einrichten einer mechanischen Verbindung des Deckels zum Wärmeleitkörper.

Mit diesem Verfahren kann ein Diodenlaser nach Anspruch 9 hergestellt werden, der die Aufgabe der Erfindung löst. Speziell kann zur Herstellung einer Klemmverbindung im o. g. erfindungsgemäßen Verfahren eine als Noppenstruktur ausgebildete zweite metallische Schicht gemäß Anspruch 11 verwendet werden.

### Vorteile der Erfindung

Das erfindungsgemäße Verfahren kann zum Herstellen eines Diodenlasers vorteilhaft verwendet werden, welcher für einen hohen Betriebsstrom ausgelegt ist. Das Verfahren ist tolerant gegen Unebenheiten des Laserbarrens und/oder der Kontaktflächen des Wärmeleitkörpers bzw. des Deckels. Somit kann die Ausbeute bei der Herstellung der Laser erhöht werden. Die p-Kontaktfläche des Laserbarrens, die dem Wärmeleitkörper zugewandt ist, weist nach der Montage eine besonders gute Ebenheit auf. Der Laserbarren kann dadurch einen möglichst geringen smile-Wert aufweisen, so dass er hervorragend zur Strahlformung geeignet ist. Weiterhin kann das Problem von Migration von Lotmaterial einer p-seitigen metallischen Schicht vermieden werden. Die Montage des Laserbarrens ist mechanisch spannungsarm. Daher können hervorragende elektrooptische Eigenschaften erreicht werden, beispielsweise ein hoher Polarisationsgrad, eine gleichmäßige Nahfeldverteilung der Laserstrahlung und eine hohe Steilheit der Leistungs-Strom- Kennlinie. Außerdem kann der p-seitige Stromeintrag verbessert werden.

### Beschreibung

Der erfindungsgemäße Diodenlaser ist eine Vorrichtung zur Emission von Laserstrahlung, welche einen Laserbarren als Strahlquelle aufweist. Der Laserbarren kann in bekannter Weise als kantenemittierender Diodenlaserbarren ausgebildet sein und einen oder bevorzugt mehrere Emitter umfassen, welche in einer y-Richtung jeweils versetzt zueinander angeordnet sein können. Der Laserbarren kann bevorzugt in y-Richtung eine Breite zwischen 0,3 mm und 12 mm haben. Er kann bevorzugt 1 bis 49 Emitter aufweisen. Die Dicke des Laserbarrens kann in einer z-Richtung bevorzugt zwischen 0,05 mm und 0,2 mm betragen. Die Länge der Emitter des Laserbarrens in einer x-Richtung kann bevorzugt zwischen 0,5 mm und 6 mm liegen. Die Richtung der Zentralstrahlen der emittierten Laserstrahlung kann die x-Richtung sein. Die Richtungen x, y und z können rechtwinklig zueinander sein. Der Laserbarren kann eine bekannte epitaktisch hergestellte Schichtfolge als p-n-Übergang mit einem oder mehreren Quantengräben aufweisen. Die Epitaxieschicht kann erheblich dünner sein, als das Substrat. Die Epitaxieschicht kann beispielsweise zwischen 3 µm und 20 µm dick sein. Das Substrat kann beispielsweise zwischen 50 µm und 200 µm dick sein. Die einzelnen Emitter können bevorzugt als Breitstreifenemitter oder als Stegwellenleiter oder als Trapezlaser ausgebildet sein. Es können auch mehrere Schichtfolgen, d. h. mehrere elektrisch in Serie liegende p-n Übergänge vorhanden sein. Solche Barren werden auch als Nanostack bezeichnet. In diesem Fall können mehrere Emitter in z-Richtung übereinander gestapelt sein.

Die Facetten des Laserbarrens können mit Spiegeln versehen sein, beispielweise kann an der rückwärtigen Facette des Laserelements eine hochreflektierende Spiegelschicht angebracht sein und an der gegenüberliegenden austrittsseitigen Facette, welche die Austrittsapertur enthält, eine niedrig reflektierende Spiegelschicht mit einem Refelxionsgrad von beispielsweise 0,1 % bis 10 %. Die Spiegel können einen Laserresonator definieren, der einen Laserbetrieb ermöglicht. Der Laserbarren kann aber auch als Gewinnelement ausgebildet sein, welches erst im Zusammenwirken mit einem externen Resonator zum Laserbetrieb vorgesehen ist. Dabei kann beispielsweise eine wellenlängenabhängige Rückkopplung durch den externen Resonator vorgesehen sein, die zur Festlegung der Wellenlänge des Lasers dient. Auch ein solches elektrooptisches Gewinnelement ist als Laserbarren im Sinne der Erfindung zu verstehen.

Der Laserbarren wird durch einen elektrischen Strom gepumpt. Der Betriebsstrom kann beispielsweise 1A bis 1000A betragen. Zum Stromeintrag sind eine erste Kontaktfläche und eine zweite Kontaktfläche am Laserbarren vorgesehen. Die p seitige Kontaktfläche wird als erste Kontaktfläche bezeichnet. Die erste Kontaktfläche kann die Anode des Diodenlaserbarrens sein. Die n-seitige Kontaktfläche des Laserbarrens wird als zweite Kontaktfläche bezeichnet.

Die zweite Kontaktfläche kann die Kathode des Laserbarrens sein. Die erste und die zweite Kontaktfläche können jeweils in einer xy-Ebene liegen. Die erste Kontaktfläche ist auf der Epitaxieseite des Laserbarrens, die als erste Seite bezeichnet werden kann, angeordnet, während die zweite Kontaktfläche auf der Substratseite des Laserbarrens, die als zweite Seite bezeichnet werden kann, angeordnet ist.

Der Laserbarren kann im Betrieb Abwärme entwickeln, welche abgeführt werden muss. Dazu ist ein Wärmeleitkörper mit einer ersten Anschlussfläche vorgesehen. Da sich der pn-Übergang des Diodenlasers in der Epitaxieschicht (d.h. nahe der ersten Seite) befinden kann und der überwiegende Teil der Abwärme im pn-Übergang entstehen kann, wird der Wärmeleitkörper an die erste Seite des Laserbarrens angeschlossen. Die erste Kontaktfläche wird elektrisch und thermisch mit der ersten Anschlussfläche verbunden und die zweite Kontaktfläche wird elektrisch mit der zweiten Anschlussfläche verbunden.

Das erfindungsgemäße Verfahren dient zum Herstellen eines Diodenlasers. Dazu wird ein Laserbarren bereitgestellt, der auf einer ersten Seite eine erste Kontaktfläche aufweist, die als wenigstens ein p-Kontakt ausgebildet ist, und auf einer der ersten Seite gegenüberliegenden Seite zweiten Seite eine zweite Kontaktfläche aufweist, die als wenigstens ein n-Kontakt ausgebildet ist. Die erste Kontaktfläche kann als eine Kontaktfläche für alle Emitter ausgebildet sein. Sie kann aber auch aus mehreren einzelnen Teilflächen bestehen, die voneinander getrennt sein können, beispielsweise eine Teilfläche für jeden Emitter. Die erste Kontaktfläche kann beispielsweise eine Metallisierung sein, die äußere Schicht kann beispielsweise eine Goldschicht sein. Bevorzugt kann dabei eine galvanisch verstärkte Goldschicht mit einer Dicke bevorzugt größer als 0,5 µm, besonders bevorzugt zwischen 1 µm und 10 µm, verwendet werden. Die zweite Kontaktfläche kann als eine Kontaktfläche für alle Emitter ausgebildet sein. Sie kann aber auch aus mehreren einzelnen Teilflächen bestehen, beispielsweise eine Teilfläche für jeden Emitter. Die zweite Kontaktfläche kann beispielsweise eine Metallisierung sein, die äußere Schicht kann beispielsweise eine Goldschicht sein.

Es können auch mehrere Laserbarren bereitgestellt werden, die beispielsweise nebeneinander oder übereinander auf der Wärmesenke angeordnet sein können.

Außerdem wird ein Wärmeleitkörper mit einer ersten Anschlussfläche bereitgestellt. Der Wärmeleitkörper kann beispielsweise wenigstens zum Teil aus Kupfer, Aluminium oder aus einem Kupfer-Diamant Aluminium-Diamant oder Silber-Diamant-Verbundwerkstoff bestehen oder ein solches Material umfassen. Er kann beispielsweise als Kupferkörper mit einem Inlay aus einem Verbundwerkstoff ausgeführt sein. Er kann aber beispielsweise auch ganz aus Kupfer gefertigt sein. Der Wärmeleitkörper kann eine Metallisierung aufweisen, beispielsweise Ag/Au, oder Ni/Au oder Ti/Pt/Au, wobei die Goldschicht vorzugsweise außen vorgesehen ist. Die erste Anschlussfläche kann mit einer besonders guten Ebenheit ausgeführt sein, um hernach einen geringen smile-Wert (Abweichung der einzelnen Emitter von einer geraden Linie) zu erreichen. Es können noch weitere erste Anschlussflächen für weitere Laserbarren vorgesehen sein.

Außerdem wird wenigstens ein Deckel mit einer zweiten Anschlussfläche bereitgestellt. Der Deckel ist zur elektrischen Kontaktierung des n-Kontakts des Laserbarrens vorgesehen. Er kann, muss aber nicht, ebenfalls zur Wärmeableitung vorgesehen sein. Er kann aus einem elektrisch gut leitfähigen Material, beispielsweise wenigstens zum Teil aus Kupfer, Aluminium oder aus einem Kupfer-Diamant Aluminium-Diamant oder Silber-Diamant-Verbundwerkstoff bestehen oder ein solches Material umfassen. Er kann beispielsweise als Kupferkörper mit einem Inlay aus einem Verbundwerkstoff ausgeführt sein. Er kann aber beispielsweise auch ganz aus Kupfer gefertigt sein. Der Deckel kann eine Metallisierung aufweisen, beispielsweise Ag/Au, oder Ni/Au oder Ti/Pt/Au, wobei die Goldschicht vorzugsweise außen vorgesehen ist.

Erfindungsgemäß wird eine zweite metallische Schicht bereitgestellt, welche in einer Schnittebene mehrere erhabene Stellen und mehrere abgesenkte Stellen aufweist. Im Sinne der vorliegenden Erfindung kann die Schichtdicke der zweiten metallischen Schicht ortsabhängig sein. Es können mehrere erhabene Stellen und/oder mehrere abgesenkte Stellen vorhanden sein. Als erhabene Stellen werden solche Stellen der zweiten metallischen Schicht bezeichnet, die ein Maximum der Schichtdicke aufweisen. Eine erhabene Stelle ist also eine solche Stelle, die weiter über die Oberfläche hinausragt als umgebende Stellen. Eine erhabene Stelle kann bei topografischer Betrachtung als Kuppe, als Plateau oder als Rücken ausgebildet sein. Als abgesenkte Stellen einer Schicht werden solche Stellen bezeichnet, die jeweils ein Minimum der Schichtdicke aufweisen. Eine abgesenkte Stelle kann bei topografischer Betrachtung als Kessel, als Mulde oder als Becken ausgebildet sein. Die Schichtdicke an den abgesenkten Stellen kann größer oder gleich Null sein. Im zweiteren Fall kann an den abgesenkten Stellen kein Schichtmaterial vorhanden sein, die Schicht kann also Unterbrechungen aufweisen. An den erhabenen Stellen kann die Schichtdicke gleich sein und einen Wert D haben. Die erhabenen Stellen können als topologisch zusammenhängende Fläche oder als mehrere Teilflächen ausgebildet sein. Die abgesenkten Stellen können als topologisch zusammenhängende Fläche oder als mehrere Teilflächen ausgebildet sein. In einer Schnittebene, welche senkrecht zur Schichtebene sein kann, können mehrere erhabene und mehrere abgesenkte Stellen angeschnitten sein. Die Schnittebene kann also so gewählt werden, dass sie eine Normale der Schichtebene enthält. In einer solchen Schnittdarstellung können beispielsweise mehrere abgesenkte Stellen sichtbar sein. Auch wenn diese Stellen bei dreidimensionaler Betrachtung als eine zusammenhängende Fläche ausgebildet sein können, kann die Schnittebene dennoch im erfindungsgemäßen Sinne die mehreren abgesenkten Stellen aufweisen. Gleiches gilt für die erhabenen Stellen. Es sei noch darauf hingewiesen, dass nicht in jeder beliebigen Schnittebene, die senkrecht zur Schichtebene ist, mehrere erhabene und mehrere abgesenkte Stellen vorhanden sein müssen. Beispielsweise können die mehreren erhabenen und abgesenkten Stellen in einem Querschnitt sichtbar sein, während sie in einem Längsschnitt nicht sichtbar sind.

In einer bevorzugten Ausführungsform können die erhabenen Stellen als streifenförmige Plateaus der Höhe D ausgebildet sein, die beispielsweise in x-Richtung verlaufen, wobei zwischen den Streifen kein Schichtmaterial vorhanden ist. Dann würde die zweite metallische Schicht im erfindungsgemäßen Sinne in einer yz-Schnittebene (Querschnitt) mehrere erhabene und mehrere abgesenkte Stellen aufweisen.

Erfindungsgemäß wird die zweite metallische Schicht, welche in einer Schnittebene mehrere erhabene Stellen und mehrere abgesenkte Stellen aufweist, dadurch bereitgestellt, dass die zweite metallische Schicht als Noppenstruktur auf die zweite Kontaktfläche oder auf die zweite Anschlussfläche aufgebracht wird. Dabei können die erhabenen Stellen als kreisförmige Plateaus der Höhe D ausgebildet sein, die man sich beispielsweise als zylinderförmige Noppen vorstellen kann, wobei zwischen den Noppen kein Schichtmaterial vorhanden ist. Eine solche Schicht kann beispielsweise durch einen Beschichtungsprozess unter Verwendung einer Lochmaske hergestellt werden. Die abgesenkten Stellen der Schicht können dann bei dreidimensionaler topologischer Betrachtung eine zusammenhängende Fläche sein. Diese Fläche könnte man als eine Tiefebene (Becken) betrachten. Dabei kann die zweite metallische Schicht im erfindungsgemäßen Sinne in einer yz-Schnittebene (Querschnitt) mehrere erhabene und mehrere abgesenkte Stellen aufweisen. Erfindungsgemäß ist die Noppenstruktur mit einer Belegungsdichte von wenigstens einer Noppe je Quadratmillimeter Schichtfläche ausgebildet, besonders vorteilhaft wenigstens 5 Noppen je Quadratmillimeter. Der Abstand benachbarter Noppen sollte nicht zu groß gewählt werden, ein maximaler Abstand von 1mm gemessen von Rand zu Rand benachbarter Noppen kann vorteilhaft sein. Die zweite metallische Schicht kann sich von herkömmlichen Lotbumps insbesondere durch die feinere Struktur und die geringere Schichtdicke unterscheiden.

Erfindungsgemäß wird der Laserbarren zwischen dem Wärmeleitkörper und dem Deckel angeordnet, wobei die erste Kontaktfläche der ersten Anschlussfläche des ersten Wärmeleitkörpers zugewandt ist und die zweite Kontaktfläche der zweiten Anschlussfläche des Deckels zugewandt ist und die zweite metallische Schicht zumindest abschnittsweise zwischen der zweiten Anschlussfläche und der zweiten Kontaktfläche angeordnet ist,

Erfindungsgemäß wird wenigstens eine Kraft erzeugt, die eine Komponente aufweist, welche den Deckel in Richtung des Wärmeleitkörpers drückt. Das kann die Richtung -z sein. Unter der Einwirkung der Kraft wird die erste Kontaktfläche flächig auf die erste Anschlussfläche gedrückt. Das kann zu einer Klemmverbindung führen. Bei diesem Andruck können Unebenheiten der zweiten Kontaktfläche ausgeglichen werden. Dabei kann der Laserbarren elastisch verformt werden. Die zweite metallische Schicht kann dabei zumindest abschnittsweise im Bereich der erhabenen Stellen eine plastische Verformung erfahren. An diesen Stellen kann die Fließgrenze des Schichtmaterials (Quetschgrenze) überschritten werden. Die zweite Kontaktfläche kann nun mit der zweiten Anschlussfläche mittels der zweiten metallischen Schicht elektrisch verbunden ist sein. An den abgesenkten Stellen kann die zweite metallische Schicht Hohlräume aufweisen. Somit kann die zweite metallische Schicht sowohl verbundene Stellen aufweisen, an denen die zweite Kontaktfläche mit der zweiten Anschlussfläche in Richtung der Normalen n durchgängig verbunden ist, und außerdem unterbrochene Stellen, an denen die zweite Kontaktfläche mit der zweiten Anschlussfläche in Richtung der Normalen n nicht durchgängig verbunden ist. Die Schichtnormale n kann die Normale der zweiten Kontaktfläche, also die z-Richtung sein. Man kann daher die verbundenen Stellen und die unterbrochenen Stellen auf eine xy-Ebene projizieren. Dabei können die unterbrochenen Stellen vorteilhaft eine Gesamtfläche aufweisen, die wenigstens 20% des Flächeninhalts der zweiten Kontaktfläche beträgt. Einzeln betrachten, sollten die unterbrochenen Stellen nicht zu groß gewählt werden, um einen ungleichmäßigen Stromeintrag in die zweite Kontaktfläche zu vermeiden. In der Projektion auf die xy Ebene sollte für jeden Punkte, der zu einer unterbrochenen Stelle gehört, der Abstand zum nächstgelegenen Punkt, der zu einer verbundenen Stelle gehört, nicht mehr als 0,5mm betragen, vorteilhaft nicht mehr als 0,25mm.

Außerdem ist das Einrichten einer mechanischen Verbindung des Deckels zum Wärmeleitkörper vorgesehen. Vorteilhaft kann eine elektrisch isolierende Verbindung vorgesehen werden, damit der Laserbarren nicht kurzgeschlossen wird. Die Verbindung kann mittels eines Fügemittels erfolgen. Als Fügemittel kann beispielsweise ein Klebstoff verwendet werden. Besonders vorteilhaft kann eine flächige Verklebung mit einem Wärmeleitklebstoff verwendet werden. Zwischen dem Laserbarren und der Fügefläche kann ein Abstand oder ein Trenngraben vorgesehen sein, um eine Benetzung des Laserbarrens mit Klebstoff zu vermeiden. Das Einrichten der mechanischen Verbindung kann mit einem Volumenschrumpf des Fügemittels einhergehen. Die mechanische Verbindung kann zum Erzeugen und/oder zur Aufrechterhaltung der Kraft vorgesehen sein. Dadurch kann auch die Klemmverbindung des Laserbarrens zwischen dem Wärmeleitkörper und dem Deckel aufrechterhalten werden.

Die zweite metallische Schicht kann als Relief ausgebildet sein. Die Schichtdicke kann ortsabhängig sein. Die Topografie der Schichtdicke kann so beschaffen sein, dass sie in einer Eintafelprojektion dargestellt werden kann. Die minimale Längendimension erhabener Stellen kann als Strukturgröße (feature size) betrachtet werden. Das kann beispielsweise der Durchmesser kreisförmiger Plateaus sein oder die Breite streifenförmiger Plateaus. Zur Bestimmung einer minimalen Strukturgröße im allgemeinen Fall können die Höhenlinien einer mittleren Höhe zwischen dem Niveau der abgesenkten Stellen und der erhabenen Stellen herangezogen werden. Die Strukturgröße kann beispielsweise der Kuppendurchmesser auf halber Kuppenhöhe bzw. die Rückenbreite auf halber Rückenhöhe sein. Die minimale Strukturgröße kann vorteilhafterweise zwischen 10µm und 1000µm liegen. Die mittlere Höhenlinie kann eine Gesamtlänge haben. Im Falle einer nicht zusammenhängenden mittleren Höhenlinie ist unter der Gesamtlänge die Summe der Längen der einzelnen Segmente der mittleren Höhenlinie zu verstehen. Anders ausgedrückt kann unter der Gesamtlänge der mittleren Höhenlinie auch die Summe der Umfänge der an der mittleren Höhenlinie geschnittenen Schnittflächen betrachtet werden. Die Gesamtlänge L der mittleren Höhenlinie innerhalb einer bestimmten Grundfläche A kann ins Verhältnis zu dieser Grundfläche, beispielsweise die Gesamtfläche der zweiten metallischen Schicht gesetzt werden. Vorteilhaft kann dieses Verhältnis, d.h. der Quotient L/A zwischen 1000m/m² und 100000m/m² liegen. Ist das Relief zu grob strukturiert, das heißt, das Verhältnis L/A zu klein, kann die plastische Deformation der zweiten metallischen Schicht beeinträchtigt sein. Ist das Relief zu fein strukturiert, das heißt, das Verhältnis L/A zu groß, kann es passieren, dass die thermische und elektrische Anbindung des Laserbarrens an den Wärmeleitkörper bzw. den Deckel mit der Zeit schlechter wird.

Die zweite metallische Schicht kann aus einem weichen Metall bestehen, das vorzugsweise eine Fließgrenze unter Druckbelastung (Quetschgrenze) von weniger als 50MPa, besonders bevorzugt weniger als 20MPa oder ganz besonders bevorzugt weniger als 10MPa.aufweist. Erfindungsgemäß umfasst die zweite metallische Schicht Indium.

Die plastische Verformung der zweiten metallischen Schicht kann ohne Erwärmung bei Zimmertemperatur erfolgen. Es kann aber auch eine Erwärmung vorgesehen sein, so dass die plastische Verformung bei einer erhöhten Temperatur stattfinden kann. Vorteilhaft kann die Temperatur unterhalb der Liquidustemperatur und/oder unterhalb der Solidustemperatur der zweiten metallischen Schicht liegen. Dadurch kann ein Aufschmelzen der zweiten metallischen Schicht vermieden werden. Es hat sich herausgestellt, dass eine vorteilhafte gleichmäßigere Leistungsverteilung der Laserstrahlung über die einzelnen Emitter eines Laserbarrens erreicht werden kann, wenn die zweite metallische Schicht nicht aufgeschmolzen wird.

Die plastische Verformung der zweiten metallischen Schicht kann ohne Volumenkompression erfolgen. Bei der Verformung kann die Dicke der zweiten metallischen Schicht zumindest abschnittsweise an den erhabenen Stellen verringert werden. Überschüssiges Material kann in Richtung der abgesenkten Stellen gedrückt werden, ohne dass das Gesamtvolumen des Materials eine merkliche Änderung erfährt. Das wäre bei einer gleichmäßig dicken Schicht nicht möglich.

Nach der plastischen Verformung der zweiten metallischen Schicht können sich an den erhabenen Stellen der zweiten metallischen Schicht intermetallische Phasen ausbilden, die eine weitere plastische Verformung einschränken oder verhindern. Solche intermetallischen Phasen können durch Diffusion beispielsweise bei Zimmertemperatur oder bei einem Temperprozess unterhalb der jeweiligen Schmelztemperatur (Solidustemperatur) des Materials der zweiten Schicht und der intermetallischen Phasen erfolgen. Ein solcher Diffusionsprozess kann sehr langsam vonstattengehen, beispielsweise kann er mehrere Minuten, Stunden, Tage, Wochen oder Monate dauern. Beispielweise können die zweite Anschlussfläche und/oder die zweite Kontaktfläche oberflächlich vergoldet ausgeführt sein. Dann kann Gold wenigstens teilweise in die beispielsweise aus Indium bestehende zweite metallische Schicht eindiffundieren. Dabei können gegenüber dem Indium sehr harte Gold-Indium Phase entstehen, die sich dann nicht mehr plastisch verformen lassen. Da die Bildung intermetallischer Phasen sehr lange dauern kann, wird die erfindungsgemäße plastische Verformung der zweiten metallischen Schicht durch die Einwirkung der Kraft nicht behindert.

Erfindungsgemäß wird außerdem eine erste metallische Schicht bereitgestellt. Beim Anordnen des Laserbarrens kann die erste metallische Schicht zumindest abschnittsweise zwischen der ersten Anschlussfläche und der ersten Kontaktfläche angeordnet ist. Die erste metallische Schicht weist eine gleichmäßige Schichtdicke auf. Das kann vorteilhaft sein, weil dann eine bessere Ebenheit der p-Seite des Laserbarrens erreich werden kann. Die erste metallische Schicht kann aus einem weichen Schwermetall, wie beispielsweise Zinn, Blei, Indium oder Cadmium bestehen oder ein solches umfassen. Bevorzugt sind Indium und/oder Zinn zu verwenden, da Blei und Cadmium weniger umweltverträglich sind.

Die erste bzw. die zweite metallische Schicht kann auch über die erste bzw. zweite Kontaktfläche hinausragen.

Die erste bzw. die zweite metallische Schicht können durch Beschichten hergestellt werden. Unter Beschichten (englisch coating) wird in der Fertigungstechnik eine Hauptgruppe der Fertigungsverfahren nach DIN 8580 verstanden, die zum Aufbringen einer haftenden Schicht aus formlosem Stoff auf die Oberfläche eines Werkstückes genutzt werden. Der entsprechende Vorgang sowie die aufgetragene Schicht selbst wird auch als Beschichtung bezeichnet. Bei einer Beschichtung kann es sich um eine dünne Schicht oder eine dicke Schicht sowie um mehrere in sich zusammenhängende Schichten handeln, die Unterscheidung ist nicht genau definiert und orientiert sich am Beschichtungsverfahren und Anwendungszweck. Im Sinne der vorliegenden Erfindung wird auch eine Beschichtung mit ortsabhängiger Schichtdicke als Schicht bezeichnet.

Die zweite metallische Schicht kann durch Beschichten der zweiten Anschlussfläche hergestellt werden. Dazu können galvanische oder physikalische (z.B. Bedampfen, Sputtern) Beschichtungsverfahren verwendet werden. Das Beschichten kann mit einer Maske erfolgen, um die abgesenkten und erhabenen Stellen herzustellen. Alternativ kann auch eine gleichmäßig dicke Schicht beschichtet werden, und die abgesenkten und erhabenen Stellen werden hernach beispielsweise durch Prägen, Ritzen oder Ätzen hergestellt. Die zweite metallische Schicht kann auch durch Beschichten der zweiten Kontaktfläche des Laserbarrens hergestellt sein.

Die zweite metallische Schicht kann auch als freitragende Schicht ausgeführt sein, die beispielsweise durch Prägen einer Metallfolie hergestellt werden kann.

Die zweite metallische Schicht ist, bezogen auf die erhabenen Stellen, dicker ausgeführt als die erste metallische Schicht. Die zweite metallische Schicht kann an den erhabenen Stellen bevorzugt eine Dicke von 3µm bis 100µm, besonders bevorzugt zwischen 5µm und 15µm aufweisen. Die erste metallische Schicht kann bevorzugt eine gleichmäßige Dicke von weniger als 5µm, besonders bevorzugt weniger als 3µm aufweisen.

Die zweite metallische Schicht kann auf die zweite Anschlussfläche aufgetragen sein. Die erste metallische Schicht kann, falls vorgesehen, auf die erste Anschlussfläche aufgetragen sein. Die zweite metallische Schicht kann auf die zweite Kontaktfläche aufgetragen sein. Die erste metallische Schicht kann, falls vorgesehen, auf die erste Kontaktfläche aufgetragen sein. Außerdem können zwischen der zweiten Kontaktfläche und der zweiten Anschlussfläche noch weitere metallische Schichten vorgesehen sein.

Die zweite metallische Schicht kann einen Volumenfüllgrad aufweisen, der bevorzugt zwischen 5% und 95% und/oder besonders bevorzugt zwischen 10% und 50% beträgt. Unter dem Volumenfüllgrad ist das Verhältnis des Materialvolumens zu dem Produkt aus Grundfläche D und Schichtdicke D der jungfräulichen (noch nicht deformierten) Schicht zu verstehen. Die Schichtdicke D ist bei dieser Berechnung die Schichtdicke an den erhabenen Stellen.

Die Erfindung beinhaltet weiterhin einen Diodenlaser gemäß Anspruch 9. Der Diodenlaser umfasst wenigstens einen kantenemittierenden Laserbarren mit einer ersten Kontaktfläche, die als ein p-Kontakt ausgebildet ist, und einer zweite Kontaktfläche, die als n-Kontakt ausgebildet ist, einen Wärmeleitkörper mit einer ersten Anschlussfläche, einen Deckels mit einer zweiten Anschlussfläche, eine zweite metallische Schicht. Der Laserbarren ist zwischen dem Wärmeleitkörper und dem Deckel angeordnet. Die zweite metallische Schicht ist zumindest abschnittsweise zwischen der zweiten Anschlussfläche und der zweiten Kontaktfläche angeordnet. Der Deckel ist mit dem Wärmeleitkörper mechanisch verbunden. Die erste Kontaktfläche ist mit der ersten Anschlussfläche des ersten Wärmeleitkörpers flächig thermisch und elektrisch verbunden. Das bedeutet, dass über diese Verbindung eine möglichst gute Wärmeableitung der Abwärme vom Laserbarren zum Wärmeleitkörper möglich ist und gleichzeitig eine möglichst niederohmige elektrische Verbindung für die Zuführung des Betriebsstromes zum Laserbarren ermöglicht wird. Die zweite Kontaktfläche ist mit der zweiten Anschlussfläche mittels der zweiten metallischen Schicht elektrisch verbunden. Das bedeutet, dass auch diese Verbindung möglichst niederohmig ausgebildet sein soll. Die zweite metallische Schicht weist verbundene Stellen auf, an denen die zweite Kontaktfläche mit der zweiten Anschlussfläche in Richtung der Normalen n, d. h der z-Richtung, durchgängig verbunden ist. Außerdem weist die zweite metallische Schicht unterbrochene Stellen auf, an denen die zweite Kontaktfläche mit der zweiten Anschlussfläche in Richtung der Normalen n nicht durchgängig verbunden ist. Maßgeblich, ob ein Punkt der schichtebene einer verbundenen Stelle oder einer unterbrochenen Stelle zuzuordnen ist, ist dabei, ob an diesem Punkt in Normalenrichtung n ein durchgängiger Stoffschluss vorhanden ist, oder ob in Normalenrichtung n wenigstens eine Hohlstelle vorhanden ist. Die Schichtnormale n kann die Normale der zweiten Kontaktfläche, also die z-Richtung sein. Man kann daher die verbundenen Stellen und die unterbrochenen Stellen auf eine xy-Ebene projizieren. Dabei können die unterbrochenen Stellen vorteilhaft eine Gesamtfläche aufweisen, die wenigstens 20 % des Flächeninhalts der zweiten Kontaktfläche beträgt. Einzeln betrachten, sollten die unterbrochenen Stellen nicht zu groß gewählt werden, um einen ungleichmäßigen Stromeintrag in die zweite Kontaktfläche zu vermeiden. In der Projektion auf die xy Ebene sollte für jeden Punkte, der zu einer unterbrochenen Stelle gehört, der Abstand zum nächstgelegenen Punkt, der zu einer verbundenen Stelle gehört, nicht mehr als 0,5mm betragen, vorteilhaft nicht mehr als 0,25mm.

Vorteilhaft kann der Deckel einen Beitrag zur Wärmeableitung von der zweiten Kontaktfläche leistend vorgesehen sein. Die Hohlstellen in der zweiten metallischen Schicht, d.h. die unterbrochenen Stellen, können frei bleiben oder alternativ mit einem weiteren Fügemittel, beispielsweise einem Epoxidharz verfüllt sein. Das Verfüllen der Hohlstellen kann in einem weiteren Verfahrensschritt erfolgen. Gegebenenfalls kann dadurch die mechanische Festigkeit der Verbindung gegenüber einer Verbindung mit unverfüllten Hohlräumen verbessert werden. Der Deckel kann mittels eines elektrisch isolierenden Fügemittels mit dem Wärmeleitkörper thermisch und mechanisch verbunden sein.

Vorteilhaft kann die erfindungsgemäße Verwendung einer unter Beteiligung eines Beschichtungsprozesses hergestellten zweiten metallischen Schicht, welche eine Noppenstruktur aufweist, wobei die Noppenstruktur eine Belegungsdichte mit wenigstens einer Noppe je Quadratmillimeter Schichtfläche aufweist, zur Herstellung einer Klemmverbindung in einem einen Diodenlaser sein, wobei die zweite metallische Schicht zwischen einer zweiten n-seitigen Kontaktfläche eines Laserbarrens und einer zweiten Anschlussfläche eines Deckels angeordnet ist und die zweite metallische Schicht auf der zweiten Kontaktfläche oder auf der zweiten Anschlussfläche angebracht ist.

Die Figuren zeigen Folgendes:
Fig. 1 zeigt das Wirkungsprinzip an einem ersten Ausführungsbeispiel vor dem Zusammenbau
Fig. 2 zeigt das Wirkungsprinzip am ersten Ausführungsbeispiel nach dem Zusammenbau;
Fig. 3 zeigt das erste Ausführungsbeispiel in einer Seitenansicht;
Fig. 4 zeigt ein zweites Ausführungsbeispiel
Fig. 5 zeigt ein drittes Ausführungsbeispiel
Fig. 6 zeigt den Deckel eines vierten Ausführungsbeispiels
Fig. 7 zeigt den Deckel eines fünften Ausführungsbeispiels
Fig. 8 zeigt den Deckel eines sechsten Ausführungsbeispiels
Fig. 9 zeigt den Deckel eines siebenten Ausführungsbeispiels
Fig. 10 zeigt einen Längsschnitt des dritten Ausführungsbeispiels
Fig. 11 zeigt einen Querschnitt des dritten Ausführungsbeispiels
Fig. 12 zeigt einen Längsschnitt des fünften Ausführungsbeispiels
Fig. 13 zeigt einen Querschnitt des fünften Ausführungsbeispiels
Fig. 14 zeigt einen Längsschnitt eines achten Ausführungsbeispiels
Fig. 15 zeigt einen Querschnitt des achten Ausführungsbeispiels
Fig. 16 zeigt einen Längsschnitt eines neunten Ausführungsbeispiels
Fig. 17 zeigt einen Querschnitt des neunten Ausführungsbeispiels
Fig. 18 zeigt einen Querschnitt eines zehnten Ausführungsbeispiels
Fig. 19 zeigt einen Querschnitt eines elften Ausführungsbeispiels
Fig. 20 zeigt eine Eintafelprojektion der zweiten metallischen Schicht

Es sei darauf hingewiesen, dass die Figuren nicht maßstäblich gezeichnet sind. Zur Veranschaulichung der Erfindung sind übertriebene Darstellungen erforderlich.

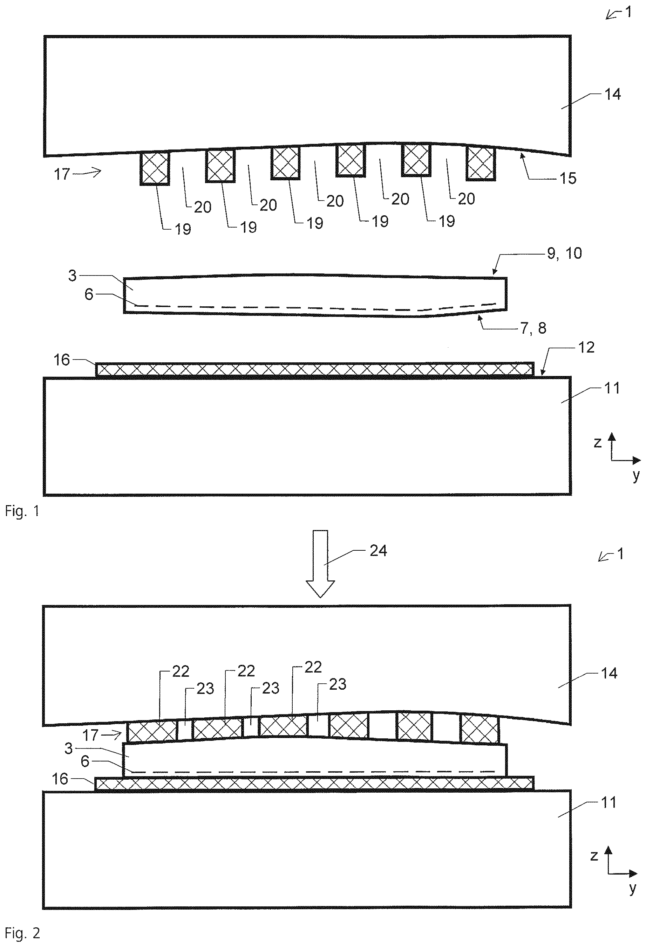

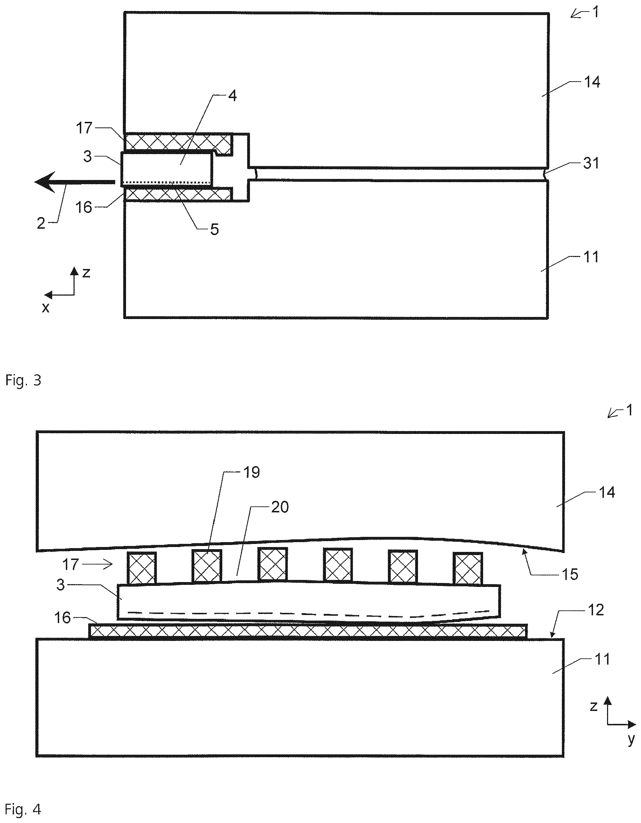

Ausführungsbeispiele:
Die Erfindung soll anhand eines ersten Ausführungsbeispiel in Fig. 1, Fig. 2 und Fig. 3 illustriert werden. Fig. 1 zeigt das Wirkungsprinzip an einem ersten Ausführungsbeispiel vor dem Zusammenbau des Diodenlasers 1 in einer Vorderansicht. Dargestellt ist ein bereitgestellter Laserbarren 3 mit mehreren Emittern 6, der auf einer ersten Seite 7 eine erste Kontaktfläche 8 aufweist, die als p-Kontakt (Anode) ausgebildet ist, und auf einer der ersten Seite gegenüberliegenden Seite zweiten Seite 9 eine zweite Kontaktfläche 10 aufweist, die als n-Kontakt (Kathode) ausgebildet ist. Der Laserbarren weist Dickenschwankungen und eine Krümmung auf. Diese Merkmale sind stark übertrieben dargestellt, um das Wirkungsprinzip der Erfindung zu verdeutlichen. Weiterhin ist ein bereitgestellter Wärmeleitkörper 11 mit einer ersten Anschlussfläche 12 dargestellt. Die erste Anschlussfläche ist mit einer ersten metallischen Schicht 16 (mit karierter Schraffur dargestellt) aus Indium beschichtet. Weiterhin ist ein bereitgestellter Deckel 14 mit einer zweiten Anschlussfläche 15 dargestellt. Diese Fläche weist eine leichte Unebenheit auf, die übertrieben dargestellt ist. Auf der zweiten Anschlussfläche ist eine zweite metallische Schicht 17 aus Indium (mit karierter Schraffur dargestellt) aufgetragen, welche mehrere erhabene Stellen 19 und mehrere abgesenkte Stellen 20 aufweist. Die zweite metallische Schicht kann somit zusammen mit dem Deckel bereitgestellt werden. An den abgesenkten Stellen 20 ist kein Schichtmaterial vorhanden. Der Laserbarrens wird zwischen dem Wärmeleitkörper 11 und dem Deckel 14 angeordnet, wobei die erste Kontaktfläche 8 der ersten Anschlussfläche 12 des Wärmeleitkörpers zugewandt ist und die zweite Kontaktfläche 10 der zweiten Anschlussfläche 15 des Deckels zugewandt ist und die zweite metallische Schicht 17 wenigstens abschnittsweise zwischen der zweiten Anschlussfläche 15 und der zweiten Kontaktfläche 10 angeordnet ist. Die zweite metallische Schicht ist in diesem Beispiel so vorgesehen, dass sie in y-Richtung nicht über die zweite Kontaktfläche hinausragt. Allerdings ragt sie in einem Abschnitt in -x Richtung über die Kontaktfläche hinaus, wie der nachfolgend beschriebenen Fig. 3 zu entnehmen ist.

Fig. 2 zeigt den Diodenlasers 1 während bzw. nach dem Zusammenbau. Es wird wenigstens eine Kraft 24 erzeugt, die eine Komponente aufweist, welche den Deckel 14 in Richtung des Wärmeleitkörpers 11 drückt. Unter der Einwirkung der Kraft wird die erste Kontaktfläche 8 flächig auf die erste Anschlussfläche 12 gedrückt wird, wobei die zweite metallische Schicht 17 zumindest abschnittsweise im Bereich der erhabenen Stellen 19 eine plastische Verformung erfährt. Das Volumen des Schichtmaterials bleibt erhalten, wobei überschüssiges Material in die abgesenkten Stellen gedrückt werden kann. Wie man erkennt, werden die o. g Unebenheiten, Dickenschwankungen und Krümmungen ausgeglichen und die Emitter 6 liegen hernach in einer Linie. Der Laserbarren kann dabei elastisch verformt werden. Die erste metallische Schicht wird nicht, bzw. kaum zusammengedrückt, da sie mit einer gleichmäßigen Dicke ausgeführt ist. Wie man sieht stellt die zweite metallische Schicht 17 an den erhabenen Stellen in Normalenrichtung, d.h. in z-Richtung eine Verbindung der zweiten Kontaktfläche zur zweiten Anschlussfläche her. An den abgesenkten Stellen besteht in Normalenrichtung keine durchgängige Verbindung der zweiten Kontaktfläche zur zweiten Anschlussfläche. dort sind unterbrochene Stellen 23 vorhanden, an welchen kein Stoffschluss vorliegt. Eine durchgängige Verbindung in Normalenrichtung besteht nur an den verbundenen Stellen 22.

Fig. 3 zeigt Einrichten einer mechanischen Verbindung des Deckels 14 zum Wärmeleitkörper 11 in einer Seitenansicht des ersten Ausführungsbeispiels. Die mechanische Verbindung erfolgt mittels eines elektrisch isolierenden Fügemittels 31. Der fertige Diodenlaser emittiert Laserstrahlung 2 in Richtung x. Es ist ebenfalls die Lage der Epitaxieschichtstruktur 5 nahe der ersten Kontaktfläche des Laserbarrens durch eine punktierte Linie angedeutet.

Es sei vorsorglich darauf hingewiesen, dass die Schraffuren in Fig. 1 bis Fig. 9 lediglich die metallischen Schichten hervorheben sollen, sie stellen keine Schnittflächen dar.

In einer Abwandlung (nicht dargestellt) des ersten Ausführungsbeispiels ist keine erste metallische Schicht vorhanden. Die erste Kontaktfläche wird direkt auf die erste Anschlussfläche aufgesetzt.

Fig. 4 zeigt die Vorderansicht eines zweiten Ausführungsbeispiel vor dem Zusammenbau des Diodenlasers 1. Die zweite metallische Schicht 17 ist auf die zweite Seite des Laserbarrens aufgetragen und wird zusammen mit dem Laserbarren bereitgestellt.

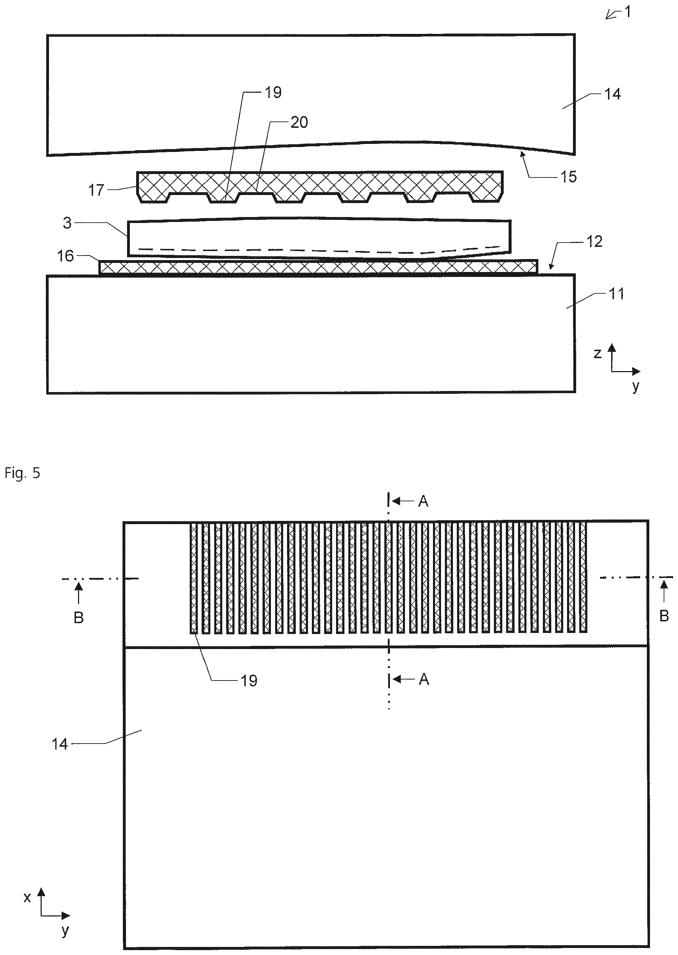

Fig. 5 zeigt die Vorderansicht eines dritten Ausführungsbeispiel vor dem Zusammenbau des Diodenlasers 1. Die zweite metallische Schicht 17 ist als freitragende Schicht bereitgestellt. In diesem Beispiel weisen die abgesenkten Stellen 20 eine Schichtdicke größer als Null auf.

Fig. 6 zeigt eine Draufsicht (Unteransicht) mit Blickrichtung z auf den Deckel 14 eines vierten Ausführungsbeispiels. Die erhabenen Stellen 19 der zweiten metallischen Schicht sind als streifenförmige Plateaus ausgeführt.

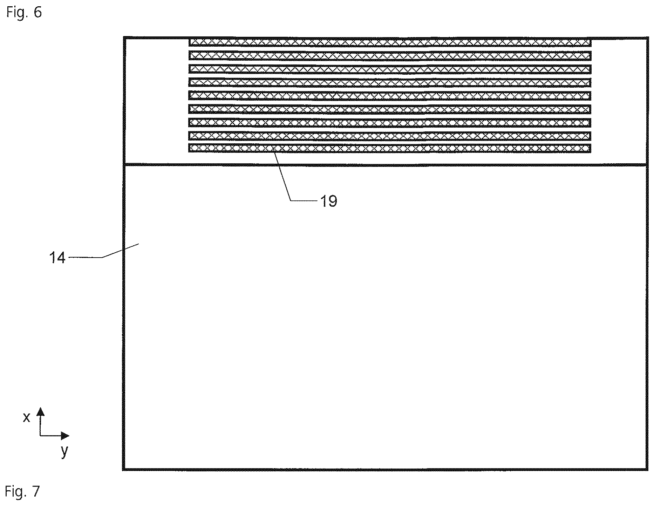

Fig. 7 zeigt eine Draufsicht (Unteransicht) mit Blickrichtung z auf den Deckel 14 eines fünften Ausführungsbeispiels. Die erhabenen Stellen 19 der zweiten metallischen Schicht sind als streifenförmige Plateaus ausgeführt.

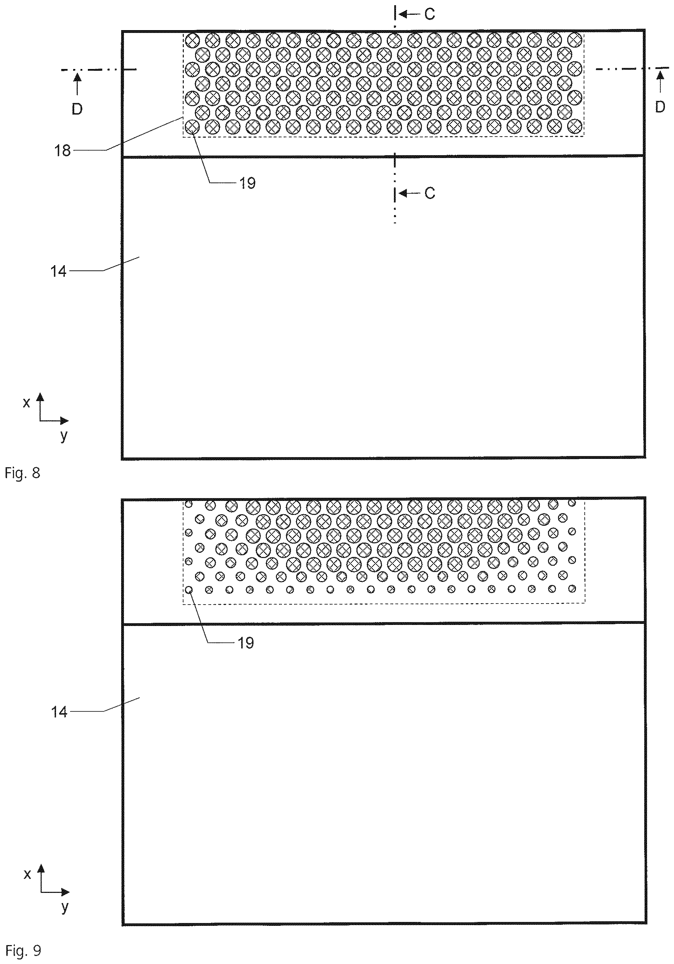

Fig. 8 zeigt eine Draufsicht (Unteransicht) mit Blickrichtung z auf den Deckel 14 eines sechsten Ausführungsbeispiels mit einer Noppenstruktur. Die erhabenen Stellen 19 der zweiten metallischen Schicht sind als kreisförmige Plateaus ausgeführt. In der Darstellung sind die erhabenen Stellen durch eine karierte Schraffur hervorgehoben. Diese Plateaus kann man auch als zylinderförmige Noppen bezeichnen. Diese Noppenstruktur ist auf einer Grundfläche A 18 vorhanden. Die abgesenkten Stellen bilden eine zusammenhängende Fläche, die man sich als Becken (Tiefebene) vorstellen kann, während die erhabenen Stellen einzelne nicht zusammenhängende Plateauflächen sind. Im topologischen Sinne ist die Tiefebene eine mehrfach zusammenhängende Fläche.

Fig. 9 zeigt eine Draufsicht (Unteransicht) mit Blickrichtung z auf den Deckel 14 eines siebenten Ausführungsbeispiels. Die erhabenen Stellen 19 der zweiten metallischen Schicht sind als kreisförmige Plateaus unterschiedlicher Größe ausgeführt. Die Noppenstruktur ist auf einer Grundfläche 18 vorhanden und über diese Fläche ungleichmäßig verteilt. Dadurch kann man einen zu hohen Druck auf den Laserbarren beispielsweise im Randbereich vermeiden.

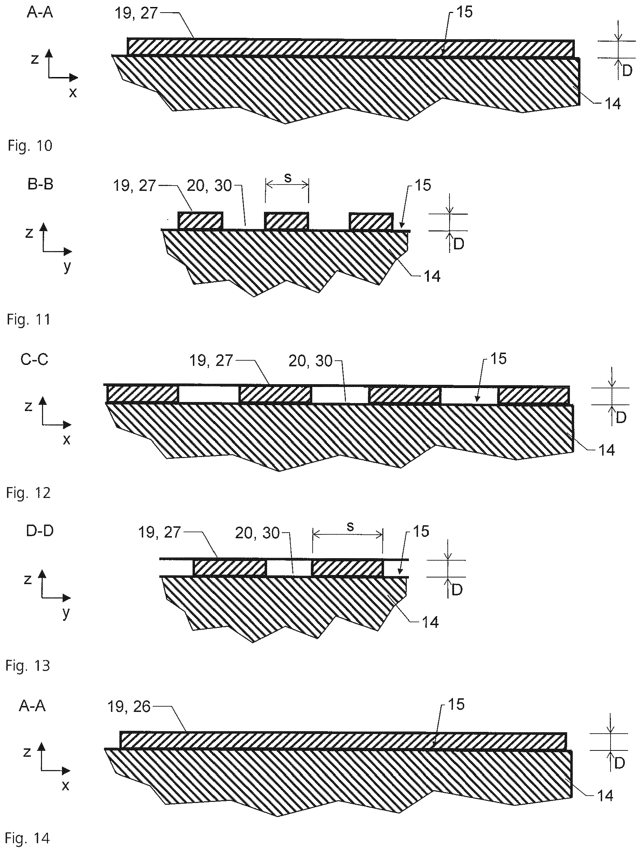

Fig. 10 zeigt einen Längsschnitt A-A des dritten Ausführungsbeispiels. Die erhabenen Stellen 19 sind als streifenförmige Plateaus 27 ausgebildet auf der zweiten Anschlussfläche 15 ausgebildet. In dieser xz-Schnittebene (Längsschnitt) ist ein streifenförmiges Plateau 27 im Schnitt dargestellt.

Fig. 11 zeigt einen Querschnitt B-B des dritten Ausführungsbeispiels. Die erhabenen Stellen 19 sind als streifenförmige Plateaus 27 auf der zweiten Anschlussfläche 15 ausgebildet, während die abgesenkten Stellen 20 als Becken 30 ausgebildet sind. Angegeben ist noch das Maß der Strukturgröße s und die Schichtdicke D, die an den erhabenen Stellen zu messen ist. In dieser yz-Schnittebene (Querschnitt) sind mehrere erhabene Stellen 19 und mehrere abgesenkte Stellen 20 vorhanden.

Fig. 12 zeigt einen Längsschnitt C-C des fünften Ausführungsbeispiels. Die erhabenen Stellen 19 sind als kreisförmige Plateaus 27 auf der zweiten Anschlussfläche 15 ausgebildet. In dieser xz-Schnittebene (Längsschnitt) sind mehrere erhabene Stellen 19 und mehrere abgesenkte Stellen 20 vorhanden.

Fig. 13 zeigt einen Querschnitt des fünften Ausführungsbeispiels. Bei diesem Beispiel sind auch in der dargestellten yz-Schnittebene (Querschnitt) mehrere erhabene Stellen 19 und mehrere abgesenkte Stellen 20 vorhanden.

Fig. 14 zeigt einen Längsschnitt eines achten Ausführungsbeispiels. Hier sind die erhabenen Stellen 19 der zweiten metallischen Schicht als Rücken 26 ausgeführt. Die Lage der Schnittebenen AA, BB, CC und DD kann denen der vorgenannten dritten und fünften Ausführungsbeispiele entsprechen.

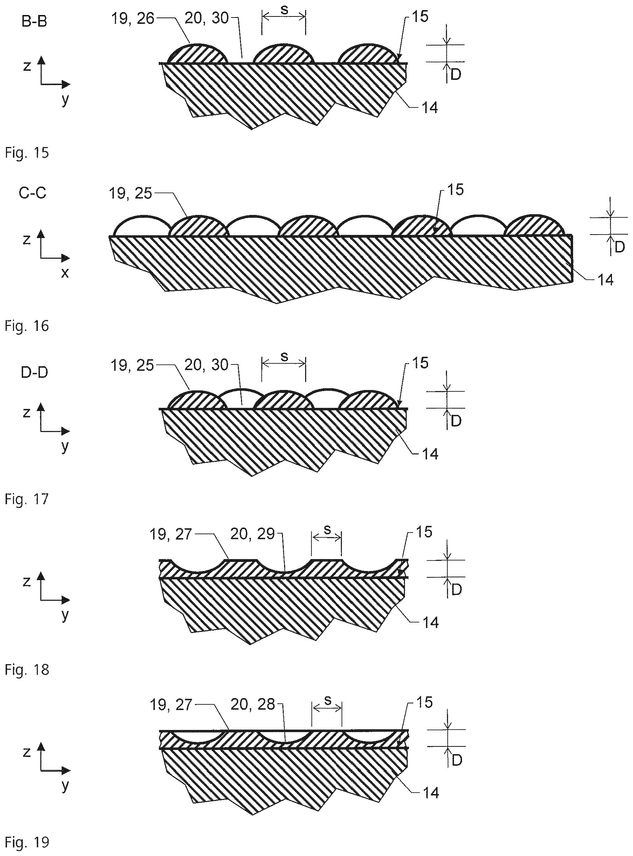

Fig. 15 zeigt einen Querschnitt eines achten Ausführungsbeispiels.

Fig. 16 zeigt einen Längsschnitt eines neunten Ausführungsbeispiels. Hier sind die erhabenen Stellen 19 der zweiten metallischen Schicht als Kuppen 25 ausgeführt. Die zweite metallische Schicht ist hier als Noppenstruktur ausgebildet.

Fig. 17 zeigt einen Querschnitt des neunten Ausführungsbeispiels.

Fig. 18 zeigt einen Querschnitt eines zehnten Ausführungsbeispiels. Hier sind die abgesenkten Stellen 20 als Mulden 29 ausgeführt.

Fig. 19 zeigt einen Querschnitt eines elften Ausführungsbeispiels. Hier sind die abgesenkten Stellen 20 als Kessel 28 ausgeführt. Die Kessel können um die Scheitelachse rotationssymmetrisch ausgeführt sein. Die erhabenen Stellen 19 bilden eine zusammenhängende Plateaufläche 27, die im topologischen Sinne mehrfach zusammenhängend sein kann. Die abgesenkten Stellen sind in diesem Falle nicht zusammenhängend, da jeder Kessel von der Plateaufläche allseitig umgeben ist.

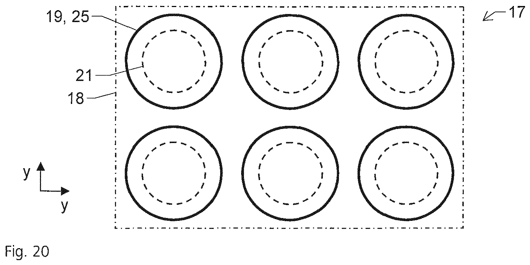

Fig. 20 zeigt eine Eintafelprojektion der zweiten metallischen Schicht 17 eines zwölften Ausführungsbeispiels. Hier sind die erhabenen Stellen 19 der zweiten metallischen Schicht als Kuppen 25 ausgeführt, die in einer Matrix angeordnet sind. An diesem Beispiel soll die Bestimmung der Höhenlinien veranschaulicht werden. Man kann eine Grundfläche A 18 mit mehreren erhabenen Stellen wählen. Das kann auch die gesamte Grundfläche der zweiten metallischen Schicht sein. Jede einzelne Kuppe weist eine mittlere Höhenlinie 21 auf, die eine bestimmte Länge hat. Die Summe aller Längen der mittleren Höhenlinie ergibt eine Gesamtlänge L. Daraus kann man das Verhältnis L/A bestimmen.

In Abwandlung (nicht dargestellt) des ersten bis zwölften Ausführungsbeispiels wird die zweite metallische Schicht durch Beschichten der zweiten Seite des Laserbarrens hergestellt. Die genannten Ausführungsbeispiele sind miteinander kombinierbar.

### Bezugszeichen:

1. Diodenlaser
2. Laserstrahlung
3. Laserbarren
4. Substrat
5. Epitaxieschicht
6. Emitter
7. erste Seite
8. erste Kontaktfläche
9. zweite Seite
10. zweite Kontaktfläche
11. Wärmeleitkörper
12. erste Anschlussfläche
13. Faserkern (core)
14. Deckel
15. zweite Anschlussfläche
16. erste metallische Schicht
17. zweite metallische Schicht
18. Grundfläche
19. erhabene Stelle
20. abgesenkte Stelle
21. mittlere Höhenlinie
22. in Normalenrichtung verbundene Stelle
23. in Normalenrichtung unterbrochene Stelle
24. Kraft
25. Kuppe
26. Rücken
27. Plateau
28. Kessel
29. Mulde
30. Becken
31. Fügemittel

## Patentansprüche

1. Verfahren zum Herstellen eines Diodenlasers (1), umfassend folgende Schritte:
a. Bereitstellen wenigstens eines Laserbarrens (3) mit mehreren Emittern (6), der auf einer ersten Seite (7) eine erste Kontaktfläche (8) aufweist, die als wenigstens ein p-Kontakt ausgebildet ist, und auf einer der ersten Seite gegenüberliegenden zweiten Seite (9), der Substratseite des Laserbarrens (3), eine zweite Kontaktfläche (10) aufweist, die als wenigstens ein n-Kontakt ausgebildet ist,
b. Bereitstellen eines Wärmeleitkörpers (11) mit einer ersten Anschlußfläche (12),
c. Bereitstellen eines Deckels (14) mit einer zweiten Anschlußfläche (15),
d. Bereitstellen einer ersten metallischen Schicht (16), wobei die erste metallische Schicht (16) eine gleichmäßige Schichtdicke aufweist,
e. Bereitstellen einer zweiten metallischen Schicht (17) als Noppenstruktur, welche in einer Schnittebene mehrere erhabene Stellen (19) und mehrere abgesenkte Stellen (20) aufweist, wobei die zweite metallische Schicht (17), bezogen auf die erhabenen Stellen (19), dicker ausgeführt ist als die erste metallische Schicht (16), wobei die zweite metallische Schicht (17) Indium umfasst, und wobei die Noppenstruktur eine Belegungsdichte mit wenigstens einer Noppe je Quadratmillimeter Schichtfläche aufweist,
f. Anordnen des Laserbarrens zwischen dem Wärmeleitkörper (11) und dem Deckel (14), wobei die erste Kontaktfläche (8) der ersten Anschlußfläche (12) des Wärmeleitkörpers zugewandt ist und die zweite Kontaktfläche (10) der zweiten Anschlußfläche (15) des Deckels zugewandt ist und beim Anordnen des Laserbarrens (3) die erste metallische Schicht (16) zumindest abschnittsweise zwischen der ersten Anschlußfläche (12) und der ersten Kontaktfläche (8) angeordnet ist und die zweite metallische Schicht (17) zumindest abschnittsweise zwischen der zweiten Anschlußfläche (15) und der zweiten Kontaktfläche (10) angeordnet ist,
g. Erzeugen wenigstens einer Kraft (24), die eine Komponente aufweist, welche den Deckel (14) in Richtung des Wärmeleitkörpers (11) drückt, wobei unter der Einwirkung der Kraft die erste Kontaktfläche (8) flächig auf die erste Anschlußfläche (12) gedrückt wird, wobei die zweite metallische Schicht (17) zumindest abschnittsweise im Bereich der erhabenen Stellen (19) eine plastische Verformung erfährt,
h. Einrichten einer mechanischen Verbindung des Deckels (14) zum Wärmeleitkörper (11).

2. Verfahren nach Anspruch 1, **dadurch gekennzeichnet, dass** die plastische Verformung der zweiten metallischen Schicht (17) bei Zimmertemperatur und/oder unterhalb der Liquidustemperatur und/oder unterhalb der Solidustemperatur der zweiten metallischen Schicht (17) erfolgt.

3. Verfahren nach einem der vorgenannten Ansprüche, **dadurch gekennzeichnet, dass** die plastische Verformung ohne Volumenkompression erfolgt und/oder dass bei der Verformung die Dicke der zweiten metallischen Schicht (17) zumindest abschnittsweise an den erhabenen Stellen (19) verringert wird.

4. Verfahren nach einem der vorgenannten Ansprüche, **dadurch gekennzeichnet, dass** die Noppenstruktur eine Belegungsdichte mit wenigstens fünf Noppen je Quadratmillimeter Schichtfläche aufweist.

5. Verfahren nach Anspruch 3, **dadurch gekennzeichnet, dass** die zweite metallische Schicht (17) an den erhabenen Stellen (19) eine Dicke zwischen 5µm und 15µm aufweist und/oder die erste metallische Schicht (16) eine gleichmäßige Dicke von weniger als 3µm aufweist.

6. Verfahren nach einem der vorgenannten Ansprüche, **dadurch gekennzeichnet, dass** die zweite metallische Schicht (17) auf die zweite Anschlußfläche (15) aufgetragen ist und/oder dass die erste metallische Schicht (16) auf die erste Anschlußfläche (12) aufgetragen ist und/oder dass die zweite metallische Schicht (17) zumindest abschnittsweise auf die zweite Kontaktfläche (10) aufgetragen ist und/oder dass die erste metallische Schicht (16) zumindest abschnittsweise auf die erste Kontaktfläche (8) aufgetragen ist.

7. Verfahren nach einem der vorgenannten Ansprüche, **dadurch gekennzeichnet, dass** die zweite metallische Schicht (17) einen Volumenfüllgrad aufweist, der zwischen 2% und 95% und/oder zwischen 5% und 50% beträgt, wobei unter dem Volumenfüllgrad das Verhältnis des Materialvolumens zu dem Produkt aus Grundfläche D und Schichtdicke D der noch nicht deformierten Schicht zu verstehen ist und die Schichtdicke D die Schichtdicke an den erhabenen Stellen (19) ist.

8. Verfahren nach einem der vorgenannten Ansprüche, **dadurch gekennzeichnet, dass** die erhabenen Stellen (19) eine minimale Strukturgröße zwischen 10µm und 1000µm aufweisen und/oder dass die zweite metallische Schicht auf einer Grundfläche A ein Relief mit einer mittleren Höhenlinie aufweist und das Verhältnis L/A der Gesamtlänge L der mittleren Höhenlinie zur Grundfläche A zwischen 1000m/m² und 100000m/m² beträgt.

9. Diodenlaser (1), umfassend wenigstens einen kantenemittierenden Laserbarren (3), welcher mehrere Emitter (6) umfasst, mit einer ersten Kontaktfläche (8), die als ein p-Kontakt ausgebildet ist, und einer zweite Kontaktfläche (10), die als n-Kontakt auf einer Substratseite des Laserbarrens (3) ausgebildet ist und eine Normale n und einen Flächeninhalt A aufweist, einen Wärmeleitkörper (11) mit einer ersten Anschlußfläche (12), einen Deckel (14) mit einer zweiten Anschlußfläche (15) und eine zweite metallische Schicht (17), welche Indium umfasst, wobei der Laserbarren (3) zwischen dem Wärmeleitkörper (11) und dem Deckel (14) angeordnet ist und die zweite metallische Schicht (17) zumindest abschnittsweise zwischen der zweiten Anschlußfläche (15) und der zweiten Kontaktfläche (10) angeordnet ist,
wobei der Deckel (14) mit dem Wärmeleitkörper (11) mechanisch verbunden ist und die erste Kontaktfläche (8) mit der ersten Anschlußfläche (12) flächig thermisch und elektrisch verbunden ist und eine erste metallische Schicht (16) zumindest abschnittsweise zwischen der ersten Anschlußfläche (12) und der ersten Kontaktfläche (8) angeordnet ist, wobei die erste metallische Schicht (16) eine gleichmäßige Schichtdicke aufweist und die zweite Kontaktfläche (10) mit der zweiten Anschlußfläche (15) mittels der zweiten metallischen Schicht (17) elektrisch verbunden ist, wobei die zweite metallische Schicht (17) als Noppenstruktur ausgebildet ist, welche verbundene Stellen (22) aufweist, an denen die zweite Kontaktfläche (10) mit der zweiten Anschlußfläche (15) in Richtung der Normalen n durchgängig verbunden ist und außerdem unterbrochene Stellen (23) aufweist, an denen die zweite Kontaktfläche (10) mit der zweiten Anschlußfläche (15) in Richtung der Normalen n nicht durchgängig verbunden ist, wobei die Noppenstruktur eine Belegungsdichte mit wenigstens einer Noppe je Quadratmillimeter Schichtfläche aufweist, und wobei die unterbrochenen Stellen eine Gesamtfläche aufweisen, die wenigstens 20% des Flächeninhalts A beträgt.

10. Diodenlaser nach Anspruch 9, **dadurch gekennzeichnet, dass** der Deckel (14) einen Beitrag zur Wärmeableitung von der zweiten Kontaktfläche (10) leistend vorgesehen ist und/ oder der Deckel (14) mittels eines elektrisch isolierenden Fügemittels (31) mit dem Wärmeleitkörper (11) thermisch und mechanisch verbunden ist.

11. Verwendung einer unter Beteiligung eines Beschichtungsprozesses hergestellten zweiten metallischen Schicht (17), welche eine Noppenstruktur aufweist, wobei die Noppenstruktur eine Belegungsdichte mit wenigstens einer Noppe je Quadratmillimeter Schichtfläche aufweist, zur Herstellung einer Klemmverbindung in einem Diodenlaser (1) nach Anspruch 9 oder 10, wobei die zweite metallische Schicht (17) zwischen einer zweiten n-seitigen Kontaktfläche (10) eines Laserbarrens (3) und einer zweiten Anschlußfläche (15) eines Deckels (14) angeordnet ist und die zweite metallische Schicht (17) auf der zweiten Kontaktfläche (10) oder auf der zweiten Anschlußfläche (15) angebracht ist.

## Claims

1. Method for producing a diode laser (1), comprising the following steps:
a. providing at least one laser bar (3) having multiple emitters (6), which has on a first side (7) a first contact area (8), which is formed as at least one p contact, and on a second side (9) opposite from the first side, the substrate side of the laser bar (3), a second contact area (10), which is formed as at least one n contact,
b. providing a heat conducting body (11) having a first terminal area (12),
c. providing a cover (14) having a second terminal area (15),
d. providing a first metallic layer (16), wherein the first metallic layer (16) has a uniform layer thickness,
e. providing a second metallic layer (17) as a nubbed structure, which has multiple raised locations (19) and multiple depressed locations (20) in a sectional plane, wherein, with respect to the raised locations (19), the second metallic layer (17) is made thicker than the first metallic layer (16), wherein the second metallic layer (17) comprises indium, and wherein the nubbed structure has a coverage density with at least one nub per square millimetre of area of the layer,
f. arranging the laser bar between the heat conducting body (11) and the cover (14), the first contact area (8) facing the first terminal area (12) of the heat conducting body and the second contact area (10) facing the second terminal area (15) of the cover, and during arrangement of the laser bar (3) the first metallic layer (16) being arranged at least in certain portions between the first terminal area (12) and the first contact area (8) and the second metallic layer (17) being arranged at least in certain portions between the second terminal area (15) and the second contact area (10),
g. producing at least one force (24), which has a component that presses the cover (14) in the direction of the heat conducting body (11), the first contact area (8) being pressed flat against the first terminal area (12) under the effect of the force, the second metallic layer (17) undergoing a plastic deformation at least in certain portions in the region of the raised locations (19),
h. establishing a mechanical connection of the cover (14) with respect to the heat conducting body (11).

2. Method according to Claim 1, **characterized in that** the plastic deformation of the second metallic layer (17) takes place at room temperature and/or below the liquidus temperature and/or below the solidus temperature of the second metallic layer (17).

3. Method according to either of the preceding claims, **characterized in that** the plastic deformation takes place without volume compression and/or **in that**, during the deformation, the thickness of the second metallic layer (17) is reduced at least in certain portions at the raised locations (19).

4. Method according to any of the preceding claims, **characterized in that** the nubbed structure has a coverage density with at least five nubs per square millimetre of area of the layer.

5. Method according to Claim 3, **characterized in that** the second metallic layer (17) has a thickness at the raised locations (19) of between 5 pm and 15 µm and/or the first metallic layer (16) has a uniform thickness of less than 3 µm.

6. Method according to any of the preceding claims, **characterized in that** the second metallic layer (17) is applied to the second terminal area (15) and/or **in that** the first metallic layer (16) is applied to the first terminal area (12) and/or **in that** the second metallic layer (17) is applied at least in certain portions to the second contact area (10) and/or **in that** the first metallic layer (16) is applied at least in certain portions to the first contact area (8).

7. Method according to any of the preceding claims, **characterized in that** the second metallic layer (17) has a degree of volume filling that is between 2% and 95% and/or between 5% and 50%, the degree of volume filling being understood to mean the ratio of the material volume to the product of base area D and layer thickness D of the not yet deformed layer, and the layer thickness D is the layer thickness at the raised locations (19).

8. Method according to any of the preceding claims, **characterized in that** the raised locations (19) have a minimum structure size of between 10 µm and 1000 µm \and/or in that the second metallic layer has on a base area A a relief with an average contour line and the ratio L/A of the overall length L of the average contour line to the base area A is between 1000 m/m² and 100 000 m/m².

9. Diode laser (1), comprising at least one edge emitting laser bar (3), which comprises multiple emitters (6), with a first contact area (8), which is formed as a p contact, and a second contact area (10), which is formed as an n contact on a substrate side of the laser bar (3) and has a normal n and an area content A, a heat conducting body (11) having a first terminal area (12), a cover (14) having a second terminal area (15) and a second metallic layer (17) which comprises indium, the laser bar (3) being arranged between the heat conducting body (11) and the cover (14) and the second metallic layer (17) being arranged at least in certain portions between the second terminal area (15) and the second contact area (10),
the cover (14) being mechanically connected to the heat conducting body (11) and the first contact area (8) being thermally and electrically connected over the surface area to the first terminal area (12) and a first metallic layer (16) being arranged at least in certain portions between the first terminal area (12) and the first contact area (8), the first metallic layer (16) having a uniform layer thickness and the second contact area (10) being electrically connected to the second terminal area (15) by means of the second metallic layer (17), the second metallic layer (17) being formed as a nubbed structure having connected locations (22) at which the second contact area (10) is continuously connected to the second terminal area (15) in the direction of the normal n, and also having interrupted locations (23), at which the second contact area (10) is not continuously connected to the second terminal area (15) in the direction of the normal n, the nubbed structure having a coverage density with at least one nub per square millimetre of area of the layer, and the interrupted locations having an overall area that is at least 20% of the area content A.

10. Diode laser according to Claim 9, **characterized in that** the cover (14) is provided as making a contribution to the heat dissipation from the second contact area (10) and/or the cover (14) is thermally and mechanically connected to the heat conducting body (11) by means of an electrically insulating joining agent (31).

11. Use of a second metallic layer (17) that is produced with the involvement of a coating process and has a nubbed structure, the nubbed structure having a coverage density with at least one nub per square millimetre of area of the layer, for producing a clamped connection in a diode laser (1) according to Claim 9 or 10, the second metallic layer (17) being arranged between a second n-side contact area (10) of a laser bar (3) and a second terminal area (15) of a cover (14) and the second metallic layer (17) being provided on the second contact area (10) or on the second terminal area (15).

## Revendications

1. Procédé de fabrication d'un laser à diode (1), comprenant les étapes suivantes :
a. la fourniture d'au moins une barre laser (3) avec plusieurs émetteurs (6), qui présente sur un premier côté (7) une première surface de contact (8), qui est configurée sous la forme d'au moins un contact p, et sur un deuxième côté (9) opposé au premier côté, le côté substrat de la barre laser (3), une deuxième surface de contact (10), qui est configurée sous la forme d'au moins un contact n,
b. la fourniture d'un corps conducteur de chaleur (11) avec une première surface de raccordement (12),
c. la fourniture d'un couvercle (14) avec une deuxième surface de raccordement (15),
d. la fourniture d'une première couche métallique (16), la première couche métallique (16) présentant une épaisseur de couche uniforme,
e. la fourniture d'une deuxième couche métallique (17) sous forme de structure à picots, qui présente dans un plan de coupe plusieurs emplacements en relief (19) et plusieurs emplacements abaissés (20), la deuxième couche métallique (17) étant réalisée sous forme plus épaisse, en ce qui concerne les emplacements en relief (19), que la première couche métallique (16), la deuxième couche métallique (17) comprenant de l'indium, et la structure à picots présentant une densité d'occupation d'au moins un picot par millimètre carré de surface de couche,
f. l'agencement de la barre laser entre le corps conducteur de chaleur (11) et le couvercle (14), la première surface de contact (8) étant tournée vers la première surface de raccordement (12) du corps conducteur de chaleur et la deuxième surface de contact (10) étant tournée vers la deuxième surface de raccordement (15) du couvercle et, lors de l'agencement de la barre laser (3), la première couche métallique (16) étant agencée au moins par sections entre la première surface de raccordement (12) et la première surface de contact (8), et la deuxième couche métallique (17) étant agencée au moins par sections entre la deuxième surface de raccordement (15) et la deuxième surface de contact (10),
g. la production d'au moins une force (24) qui présente une composante qui presse le couvercle (14) en direction du corps conducteur de chaleur (11), la première surface de contact (8) étant pressée à plat sur la première surface de raccordement (12) sous l'effet de la force, la deuxième couche métallique (17) subissant au moins par sections une déformation plastique dans la zone des emplacements en relief (19),
h. l'établissement d'une liaison mécanique entre le couvercle (14) et le corps conducteur de chaleur (11).

2. Procédé selon la revendication 1, **caractérisé en ce que** la déformation plastique de la deuxième couche métallique (17) est réalisée à température ambiante et/ou en dessous de la température du liquidus et/ou en dessous de la température du solidus de la deuxième couche métallique (17).

3. Procédé selon l'une quelconque des revendications précédentes, **caractérisé en ce que** la déformation plastique s'effectue sans compression de volume et/ou **en ce que**, lors de la déformation, l'épaisseur de la deuxième couche métallique (17) est réduite au moins par sections aux emplacements en relief (19).

4. Procédé selon l'une quelconque des revendications précédentes, **caractérisé en ce que** la structure à picots présente une densité d'occupation d'au moins cinq picots par millimètre carré de surface de couche.

5. Procédé selon la revendication 3, **caractérisé en ce que** la deuxième couche métallique (17) présente, aux emplacements en relief (19), une épaisseur comprise entre 5 µm et 15 µm et/ou la première couche métallique (16) présente une épaisseur uniforme inférieure à 3 pm.

6. Procédé selon l'une quelconque des revendications précédentes, **caractérisé en ce que** la deuxième couche métallique (17) est appliquée sur la deuxième surface de raccordement (15) et/ou **en ce que** la première couche métallique (16) est appliquée sur la première surface de raccordement (12) et/ou **en ce que** la deuxième couche métallique (17) est appliquée au moins par sections sur la deuxième surface de contact (10) et/ou **en ce que** la première couche métallique (16) est appliquée au moins par sections sur la première surface de contact (8).

7. Procédé selon l'une quelconque des revendications susmentionnées, **caractérisé en ce que** la deuxième couche métallique (17) présente un taux de remplissage volumique qui est compris entre 2 % et 95 % et/ou entre 5 % et 50 %, le taux de remplissage volumique étant le rapport entre le volume de matériau et le produit de la surface de base D et de l'épaisseur de couche D de la couche encore non déformée, et l'épaisseur de couche D étant l'épaisseur de couche aux emplacements en relief (19).

8. Procédé selon l'une quelconque des revendications précédentes, **caractérisé en ce que** les emplacements en relief (19) présentent une taille de structure minimale comprise entre 10 µm et 1 000 µm et/ou **en ce que** la deuxième couche métallique présente sur une surface de base A un relief avec une ligne de hauteur moyenne et le rapport L/A de la longueur totale L de la ligne de hauteur moyenne à la surface de base A est compris entre 1 000 m/m² et 100 000 m/m².

9. Laser à diode (1), comprenant au moins une barre laser (3) à émission par le bord, qui comprend plusieurs émetteurs (6), avec une première surface de contact (8) qui est configurée sous la forme d'un contact p et une deuxième surface de contact (10) qui est configurée sous la forme d'un contact n sur un côté substrat de la barre laser (3) et présente une normale n et une surface A, un corps conducteur de chaleur (11) avec une première surface de raccordement (12), un couvercle (14) avec une deuxième surface de raccordement (15) et une deuxième couche métallique (17) qui comprend de l'indium, la barre laser (3) étant agencée entre le corps conducteur de chaleur (11) et le couvercle (14), et la deuxième couche métallique (17) étant agencée au moins par sections entre la deuxième surface de raccordement (15) et la deuxième surface de contact (10),
le couvercle (14) étant relié mécaniquement au corps conducteur de chaleur (11) et la première surface de contact (8) étant reliée thermiquement et électriquement à plat à la première surface de raccordement (12) et une première couche métallique (16) étant agencée au moins par sections entre la première surface de raccordement (12) et la première surface de contact (8), la première couche métallique (16) présentant une épaisseur de couche uniforme et la deuxième surface de contact (10) étant reliée électriquement à la deuxième surface de raccordement (15) au moyen de la deuxième couche métallique (17), la deuxième couche métallique (17) étant configurée sous forme de structure à picots qui présente des emplacements reliés (22), au niveau desquels la deuxième surface de contact (10) est reliée de manière continue à la deuxième surface de raccordement (15) dans la direction de la normale n et présente en outre des emplacements interrompus (23) au niveau desquels la deuxième surface de contact (10) n'est pas reliée de manière continue à la deuxième surface de raccordement (15) dans la direction de la normale n, la structure à picots présentant une densité d'occupation d'au moins un picot par millimètre carré de surface de couche, et les emplacements interrompus présentant une surface totale qui représente au moins 20 % de la surface A.

10. Laser à diode selon la revendication 9, **caractérisé en ce que** le couvercle (14) est prévu pour fournir une contribution à la dissipation de chaleur de la deuxième surface de contact (10) et/ou le couvercle (14) est relié thermiquement et mécaniquement au corps conducteur de chaleur (11) au moyen d'un moyen de joint (31) électriquement isolant.

11. Utilisation d'une deuxième couche métallique (17) fabriquée avec la participation d'un processus de revêtement, qui présente une structure à picots, la structure à picots présentant une densité d'occupation d'au moins un picot par millimètre carré de surface de couche, pour la fabrication d'une liaison par serrage dans un laser à diode (1) selon la revendication 9 ou 10, la deuxième couche métallique (17) étant agencée entre une deuxième surface de contact du côté n (10) d'une barre laser (3) et une deuxième surface de raccordement (15) d'un couvercle (14) et la deuxième couche métallique (17) étant appliquée sur la deuxième surface de contact (10) ou sur la deuxième surface de raccordement (15).
